# EUROPEAN PATENT SPECIFICATION

(11) **EP 3 388 783 B1**
(45) Date of publication and mention of the grant of the patent: **03.06.2020**
(21) Application number: 16872681.8
(22) Date of filing: 28.09.2016
(51) Int. Cl.: G01B 15/02, G01N 23/16

(54) **THICKNESS MEASURING DEVICE**
DICKENMESSUNGSVORRICHTUNG
DISPOSITIF DE MESURE D'ÉPAISSEUR

(30) Priority: 10.12.2015 JP 2015241540
(43) Date of publication of application: 17.10.2018
(73) Proprietor: Kabushiki Kaisha Toshiba, Minato-ku Tokyo 105-8001 (JP); Toshiba Infrastructure Systems & Solutions Corporation, Kawasaki-shi, Kanagawa 212-0013 (JP)
(72) Inventor: YONEKAWA, Sakae, Tokyo 105-8001 (JP)
(74) Representative: Hoffmann Eitle
(86) International application number: PCT/JP2016/078655
(87) International publication number: WO 2017/098781

(56) References cited:
- EP-A1- 2 894 433
- WO-A1-2009/128329
- JP-A- S6 024 407
- JP-A- S6 486 939
- JP-A- 2000 151 405
- JP-A- 2006 184 183
- JP-A- 2006 184 183
- JP-A- 2014 006 243
- JP-A- 2014 049 916
- JP-B1- 5 764 709

## Description

### FIELD

Embodiments described herein relate generally to a thickness measuring device.

### BACKGROUND

Conventionally, thickness measuring devices are used in sheet metal rolling process for irradiating a rolled sheet metal with radiation to measure the thickness of the sheet metal from the attenuation of the radiation having transmitted through the sheet metal. Such a thickness measuring device includes a radiation detector that detects radiation, an analog/digital (A/D) converter that converts a detection signal to a digital value, and a control unit that calculates a sheet thickness.

Another known thickness measuring devices use an A/D converter with a wide thickness measurement range and an A/D converter adopted for a signal level with a wider width, to be able to accurately measure both thick objects and thin objects.

However, accurate thickness measurement is unfeasible in the case of a malfunction and non-normal outputs of the A/D converter due to deterioration over time, for example.

Concerning the prior art, JP S60 24407 A discloses thickness measurement with a radiation source. The therein disclosed detector can be split into two or three systems, each system having an A/D-converter to which the detector channels of that system are connected. This allows channels to be bypassed in case there are abnormal readings. JP 2006 184183 discloses thickness measurement using radiation absorption. EP 2 894 433 A1 discloses an X-ray thickness gauge.

An object of the present invention is to provide a thickness measuring device that can implement accurate thickness measurement irrespective of anomaly of an A/D converter.

The invention is defined in the appended claims.

### BRIEF DESCRIPTION OF DRAWINGS

FIG. 1 is a block diagram illustrating a configuration of a thickness measuring device according to a first embodiment.
FIG. 2 is a flowchart illustrating an operation of a control unit of the first embodiment.
FIG. 3 is an example of anomaly detection of each of A/D converters of the first embodiment.
FIG. 4 is a transition diagram of an output signal of each of A/D converters of a second embodiment.
FIG. 5 is a block diagram illustrating a configuration of a thickness measuring device according to a third embodiment.
FIG. 6 is a correlation diagram between a detection signal and noise relative to a thickness in the third embodiment.
FIG. 7 is a block diagram illustrating a configuration of a thickness measuring device according to a fourth embodiment.
FIG. 8 is a flowchart illustrating an operation of a control unit of the fourth embodiment.

### DETAILED DESCRIPTION

A thickness measuring device according to one embodiment, comprising: a radiation source that irradiates a measurement object with radiation; a radiation detector that is disposed facing the radiation source across the measurement object, and that detects the radiation having transmitted through the measurement object; multiple A/D converters that are individually connected to the radiation detector, and that convert output signals from the radiation detector to digital values; a thickness calculator that calculates a thickness of the measurement object based on the digital values from the A/D converters; an anomaly detector that individually detects anomaly of the A/D converters; and an excluder that excludes an A/D converter having an anomaly detected by the anomaly detector, from subjects of calculation by the thickness calculator.

Hereinafter, embodiments of a thickness measuring device will be described in detail with reference to the accompanying drawings.

### (First Embodiment)

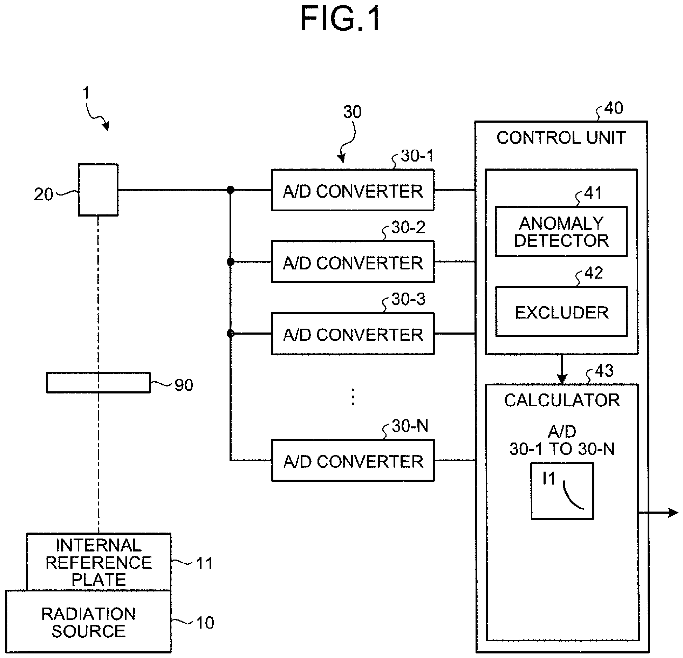

FIG. 1 is a block diagram illustrating a configuration of a thickness measuring device 1 according to a first embodiment. The thickness measuring device 1 of the present embodiment includes a radiation source 10, an internal reference plate 11, a radiation detector 20, a plurality of A/D converters 30, and a control unit 40.

The radiation source 10 is a device that irradiates an measurement object 90 with radiation. Radiation is exemplified by X-rays. However, it is not limited thereto.

The internal reference plate 11 is inserted under the radiation emitted from the radiation source 10, and is subjected to calibration in advance for creating calibration curve parameters. The internal reference plate 11 may be omitted in the present and subsequent embodiments.

The radiation detector 20 is a device that detects radiation having transmitted through the measurement object 90. The radiation detector 20 is disposed facing the radiation source 10 across the measurement object 90.

The A/D converters 30 are an aggregate of N (N being a natural number of 2 or more) A/D converters. The N A/D converters are referred to as A/D converters 30-1 to 30-N. The A/D converters 30-1 to 30-N are individually connected to the radiation detector 20, and each of them converts an output signal (radiation detection signal) from the radiation detector 20 to a digital value.

The control unit 40 includes an anomaly detector 41 (anomaly detector) for anomaly detection of each of the A/D converters 30, an excluder 42 (excluder) that excludes, when the anomaly detector has detected anomaly from any of the A/D converters, the A/D converter having anomaly from subjects of thickness calculation of the measurement object 90, and a calculator 43 (thickness calculator) that calculates the thickness of the measurement object 90 on the basis of the digital values from the A/D converters 30.

Hereinafter, the thickness measurement of the measurement object 90 by the thickness measuring device 1 of the present embodiment will be described in detail. A user of the thickness measuring device 1 sets a target value for the measurement object 90. The thickness measuring device 1 rolls the measurement object 90 to the target thickness through a rolling process. In the rolling process, the radiation source 10 irradiates, with radiation such as X rays, the measurement object 90 while being passed between the radiation source 10 and the radiation detector 20. The radiation detector 20 detects the radiation having transmitted through the measurement object 90.

The A/D converters 30, i.e., the A/D converters 30-1 to 30-N are independently connected to the radiation detector 20, so that each of the A/D converters 30-1 to 30-N converts an output signal from the radiation detector 20 to a digital value. In other words, the number of digital values is N.

A malfunction of any of the A/D converters 30 may cause a decrease in the accuracy of the thickness of the measurement object 90 when the thickness is calculated from the digital value output from the malfunctioning A/D converter.

According to the thickness measuring device 1 of the present embodiment, when the anomaly detector (anomaly detector 41) of the control unit 40 detects the malfunction of the A/D converter concerned, and the excluder (excluder 42) excludes the A/D converter concerned from subjects of the thickness calculation.

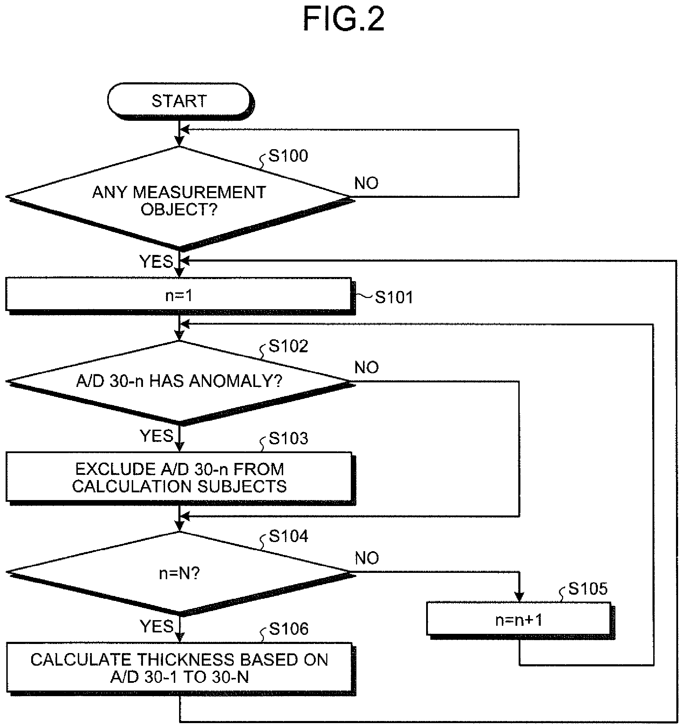

FIG. 2 is a flowchart illustrating the operation of the control unit 40 of the first embodiment. The operation of the control unit 40 will be described with reference to the flowchart in FIG. 2.

The control unit 40 determines whether there is a measurement object 90 between the radiation source 10 and the radiation detector 20 (step S100). With no measurement object 90 found (No at step S100), the control unit 40 continues to determine presence or absence of the measurement object 90. With the measurement object 90 found (Yes at step S100), the control unit 40 receives N digital values from the A/D converters 30, defines a variable n to be 1 (step S101), and detects normalcy or anomaly of the A/D converter 30-n (A/D converter 30-1) (anomaly detector, step S102).

If an anomaly of the A/D converter 30-n is detected (Yes at step S102), the excluder 42 excludes the A/D converter 30-n from the subjects of the thickness calculation of the measurement object 90 (excluder, step S103). After excluding the A/D converter 30-n having the detected anomaly from the subjects of calculation or upon detecting no anomaly from the A/D converter 30-n (No at step S102), the control unit 40 determines whether the variable n is equal to the total number N of the A/D converters (step S104). If they differ (No at step S104), the control unit 40 adds 1 to the variable n (step S105), and detects normalcy or anomaly of a next A/D converter 30-n (A/D converter 30-2) (anomaly detector, step S102).

Upon completion of the anomaly detection of all the A/D converters, when the variable n becomes equal to the total number N of the A/D converters (Yes at step S104), the calculator 43 of the control unit 40 calculates the thickness of the measurement object 90 on the basis of the non-excluded ones of the A/D converters 30-1 to 30-N (thickness calculator, step S106).

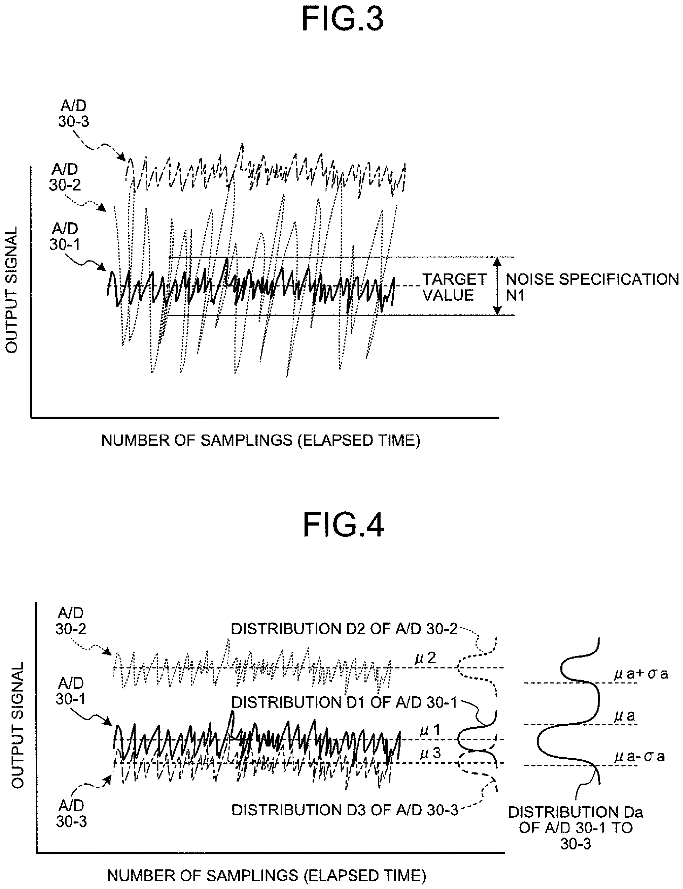

The anomaly detector (anomaly detector 41) of the control unit 40 will now be described with reference to FIG. 3. FIG. 3 is an example of anomaly detection of each of the A/D converters, and is a transition diagram of the number of samplings of the A/D converters 30-1 to 30-3 and the output signal from each of the A/D converters. The number of the A/D converters 30 is set to three (N = 3).

The horizontal axis indicates the number of samplings of each of the A/D converters, and the vertical axis indicates the output value of each of the A/D converters. The number of samplings in the horizontal axis may also be considered as elapsed time in measuring the thickness of the measurement object 90. In FIG. 3, the output of each of the A/D converters varies due to fluctuations in the intensity of the X-rays emitted from the radiation source 10. In the diagram, the fluctuations are exaggeratingly illustrated for easy understanding.

Herein, a certain width relative to the set target value is defined as a noise specification N1. The anomaly detector (anomaly detector 41) of the control unit 40 determines anomaly or normalcy of each of the A/D converters 30-1 to 30-3 from the noise specification N1.

The output value (solid line) of the A/D converter 30-1 contains noise of a certain width around the target value, but the width of the noise falls within the noise specification N1. In this case, the anomaly detector (anomaly detector 41) of the control unit 40 determines that the A/D converter 30-1 has no anomaly because the output value thereof falls within the noise specification N1.

Similar to the A/D converter 30-1, the output value (dotted line) of the A/D converter 30-2 fluctuates around the target value. However, the width of the noise is wider than the noise specification N1. In other words, the width of the output value of the A/D converter 30-2 is equal to or more than the width of the noise specification N1 being the certain width relative to the target value. In this case, the anomaly detector (anomaly detector 41) of the control unit 40 determines that the A/D converter 30-2 has anomaly.

The width of noise in the output value (alternate long and short dash line) of the A/D converter 30-3 is substantially the same as that of the A/D converter 30-1. However, the central value thereof is outside the range of the noise specification N1. In other words, the central value of the output values of the A/D converter 30-3 is outside the range of the noise specification N1 being the certain width relative to the target value. In this case, the anomaly detector (anomaly detector 41) of the control unit 40 also determines that the A/D converter 30-3 has anomaly.

The excluder (excluder 42) of the control unit 40 excludes the output values of the A/D converters 30-2 and 30-3 as determined to have anomaly by the anomaly detector (anomaly detector 41) of the present embodiment, from the subjects of the calculation.

The thickness calculator (calculator 43) of the control unit 40 excludes the digital values, i.e., the output values of the A/D converters 30-2 and 30-3 to calculate the thickness of the measurement object 90. The thickness calculator (calculator 43) includes calibration curve parameters of a detection signal (I1) relative to the thickness of the internal reference plate 11, and calculates the thickness of the measurement object 90 using the calibration curve parameters.

In the first embodiment as above, the A/D converter having the output value of the width matching or exceeding the certain width of the noise specification and the A/D converters having the central value of the output values exceeding the certain width of the noise specification are detected as non-normal.

As described above, the thickness measuring device 1 of the present embodiment excludes from the subjects of the thickness calculation the non-normal output values of the A/D converters that malfunction, therefore, can accurately measure the thickness of the measurement object 90.

### (Second Embodiment)

The block diagram of the thickness measuring device 1 of a second embodiment has the same structure as that of the first embodiment, and is the same as FIG. 1. The thickness measuring device 1 of the present embodiment is different from the thickness measuring device 1 of the first embodiment in the anomaly determination method performed by the anomaly detector (anomaly detector 41).

The anomaly detector (anomaly detector 41) of the present embodiment will be described with reference to FIG. 4. FIG. 4 is an example of anomaly detection of each of the A/D converters in the second embodiment, and a transition diagram of the number of samplings of the A/D converters 30-1 to 30-3 and the output signal from each of the A/D converters. The number of A/D converters of the A/D converters 30 is set to three (N = 3).

Similar to FIG. 3, the horizontal axis indicates the number of samplings of each of the A/D converters, and the vertical axis indicates the output value of each of the A/D converters. The number of samplings in the horizontal axis may also be considered as elapsed time in measuring the thickness of the measurement object 90.

FIG. 4 shows respective distributions D1 to D3 of output values of the A/D converters 30-1 to 30-3, and distribution Da of all the output values of the A/D converters 30-1 to 30-3.

The central value of the output values of the A/D converter 30-1 is referred to as µ1, the central value of the output values of the A/D converter 30-2 is referred to as µ2, the central value of the output values of the A/D converter 30-3 is referred to as µ3, and the central value of the output values of the A/D converter 30-N is referred to as µN.

The central value of the output values of all the A/D converters 30-1 to 30-N is referred to as µa.

The standard deviation of all the output values of the A/D converters 30-1 to 30-N is referred to as σa_{.}

The anomaly detector (anomaly detector 41) of the control unit 40 determines normalcy or anomaly of each of the A/D converters depending on whether the central value µi (i = 1 to N) of the output values of each of the A/D converters satisfies the following formula (1).

µa - σa < µi < µa + σa (i = 1 to N) ... formula (1)

When the central value µi of the output values of the A/D converter concerned satisfies the formula (1), the central value µi falls within the range of standard deviation σa. Thus, the anomaly detector (anomaly detector 41) determines that the A/D converter has no anomaly.

When the central value µi of the output values of the A/D converter concerned does not satisfy the formula (1), the central value µi is outside the range of standard deviation σa. Thus, the anomaly detector (anomaly detector 41) determines that the A/D converter has anomaly.

In the example of the A/D converters 30-1 to the 30-3 in FIG. 4, the central value µ1 of the A/D converter 30-1 and the central value µ3 of the A/D converter 30-3 are within the range of standard deviation (µa ± σa). That is, the anomaly detector (anomaly detector 41) determines that the A/D converter 30-1 and the A/D converter 30-3 have no anomaly.

The central value µ2 of the A/D converter 30-2 is outside the range of standard deviation (µa ± σa). Consequently, the anomaly detector (anomaly detector 41) determines that the A/D converter 30-2 has anomaly.

The excluder (excluder 42) of the control unit 40 excludes, from the subjects of the calculation, the output values of the A/D converter 30-2 as determined to be non-normal by the anomaly detector (anomaly detector 41) of the present embodiment.

The thickness calculator (calculator 43) of the control unit 40 excludes the digital values being the output values of the A/D converter 30-2 from the subjects of the calculation to calculate the thickness of the measurement object 90. The thickness calculator (calculator 43) includes calibration curve parameters of the detection signal (I1) relative to the thickness of the internal reference plate 11, and use the parameters to calculate the thickness of the measurement object 90.

In the second embodiment, thus, anomaly of the A/D converter is detected when the central value of the output values thereof falls outside the range of standard deviation.

As described above, if any of the A/D converters malfunctions, the thickness measuring device 1 of the present embodiment excludes non-normal output values thereof from the subjects of the thickness calculation, therefore, can accurately measure the thickness of the measurement object 90.

When two or more A/D converters are determined to have no anomaly by the anomaly detector (anomaly detector 41), the thickness measuring device 1 of the second embodiment calculates the thickness of the measurement object 90 from the average of the output values of the A/D converters concerned. The calculator 43 calculates the average output value, ([30-1] + [30-2] + [30-3]) / N, of the A/D converters 30-1 to 30-N having no anomaly to thereby obtain a measurement value. This lowers S/N ratio to 1/√n.

In measuring the thickness of the measurement object 90, the thickness calculator (calculator 43) can reduce noise components by calculating the average of the output values of the A/D converters.

As described above, if any of the A/D converters malfunctions, the thickness measuring device 1 of the present embodiment excludes non-normal output values of the A/D converter from the subjects of the thickness calculation, therefore, can accurately measure the thickness of the measurement object 90 with the noise components reduced.

### (Third Embodiment)

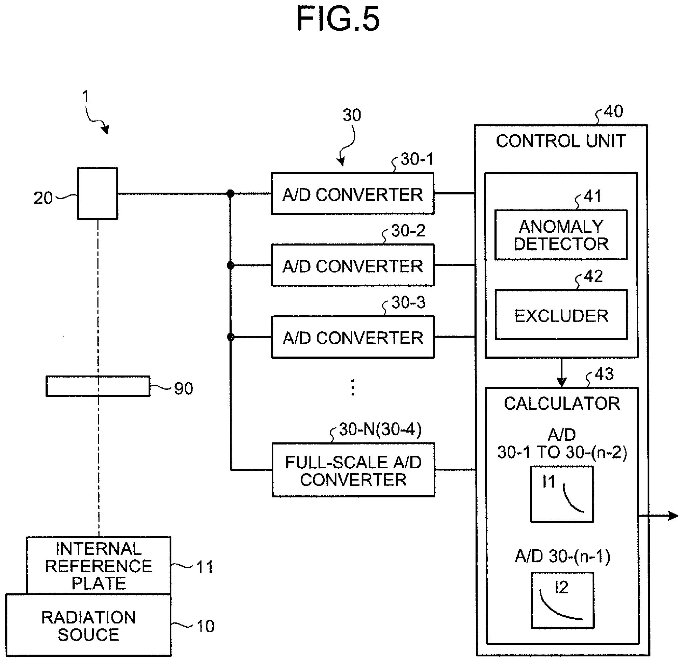

According to the thickness measuring device 1 of a third embodiment as illustrated in the block diagram of FIG. 5, one of the A/D converters is set to a full-scale measurement range. The control unit 40 determines presence or absence of the measurement object 90 on the basis of the output from the full-scale A/D converter. The thickness measuring device 1 of the present embodiment differs from the thickness measuring devices in the first embodiment and the second embodiment in that one of the A/D converters is set as a full-scale A/D converter. In the present embodiment, the number of the A/D converters is set to N, and the N-th A/D converter is set as a full-scale A/D converter.

The relation between a thickness T and a detection signal I of the measurement object 90 having a certain thickness is linear. The detection signal I with respect to a thin thickness T is non-linear due to an influence of electrical noise in the A/D converters. Herein, a region where the detection signal I with respect to the thickness T is linear is referred to as a linear region, and a region where the detection signal I with respect to the thickness T is non-linear is referred to as a non-linear region.

When the thickness T exceeds the certain thickness, the detection signal I is in low level, and noise N (S/N ratio) is high.

For determining presence of a measurement object 90 and measuring the thickness with one conventional A/D converter alone, it is difficult to accurately measure the thickness of the measurement object 90 when the thickness T is thin and falls in the non-linear region or exceeds the certain thickness.

Supposed that the thickness measuring device includes one A/D converter for thickness measurement of the measurement object 90 and one full-scale A/D converter for presence or absence determination of the measurement object 90. If the A/D converter for thickness measurement outputs non-normal values due to a malfunction, the thickness measuring device cannot accurately, continuously measure the thickness of the measurement object 90.

The thickness measuring device 1 of the present embodiment includes an A/D converter for presence or absence determination of the measurement object 90 and two or more A/D converters for thickness measurement. While presence or absence of the measurement object 90 is determined, upon detection of anomaly of an A/D converter for thickness measurement by the anomaly detector (anomaly detector 41), the excluder (excluder 42) excludes the A/D converter, and the thickness calculator (calculator 43) then calculates the thickness of the measurement object 90.

In the example of FIG. 5, the control unit 40 determines presence or absence of the measurement object 90 on the basis of the output from the full-scale A/D converter 30-N, and the A/D converters 30-1 to 30-3 for thickness measurement measure the thickness of the measurement object 90. The anomaly detector (anomaly detector 41) is the same as the anomaly detector (anomaly detector 41) of the first embodiment or the second embodiment, and determines anomaly or normalcy of the A/D converters 30-1 to 30-3 for thickness measurement.

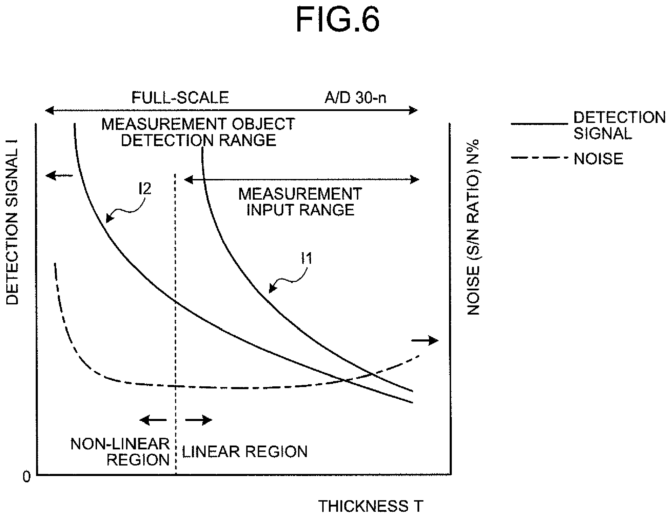

FIG. 6 is a correlation diagram between a detection signal and noise relative to a thickness in the third embodiment. The horizontal axis indicates the thickness T of the measurement object 90. The left vertical axis indicates the detection signals I of the A/D converters relative to the thickness T, and the right vertical axis indicates the noise (S/N ratio) N in the detection signals I relative to the thickness T.

A detection signal I1 is of the A/D converter for thickness measurement, and a detection signal 12 is of the A/D converter for detecting presence or absence of the measurement object 90. The detection signals I1 and I2 represent current values detected by the radiation detector 20, and the calibration curves are calculated by the detection signals.

The detection signal 12 exhibits linearity in the region of a large thickness T. In the region of a small thickness T, the smaller the thickness T is, the larger the variation the detection signal exhibits. Hereinafter, the region of a large thickness T is referred to as a linear region, and the region of a small thickness T is referred to as a non-linear region.

When the measurement input range of the A/D converter is set in the linear region, the detection signal I1 more greatly varies as the thickness T decreases in the linear region. Thus, in the linear region, the A/D converter for thickness measurement can more accurately measure the thickness of the measurement object 90 than the A/D converter for presence or absence determination of the measurement object 90.

As for the noise (S/N ratio) N, in the non-linear region the smaller the thickness T is, the larger the variation the detection signal exhibits, while in the linear region the thickness T is substantially constant till a certain thickness.

The thickness calculator (calculator 43) of the control unit 40 includes calibration curve parameters of the detection signals I1 and I2 relative to the thickness of the measurement object 90, and calculates the thickness of the measurement object 90 using the calibration curve parameters.

As described above, the thickness measuring device 1 of the present embodiment uses the A/D converters for thickness measurement and the A/D converter for presence or absence determination of the measurement object 90 to calculate the thickness of the measurement object 90, and further detects anomaly of the A/D converter for thickness measurement if it occurs, and excludes the A/D converter having anomaly. Thereby, the thickness measuring device 1 can accurately measure the thickness of the measurement object 90.

### (Fourth Embodiment)

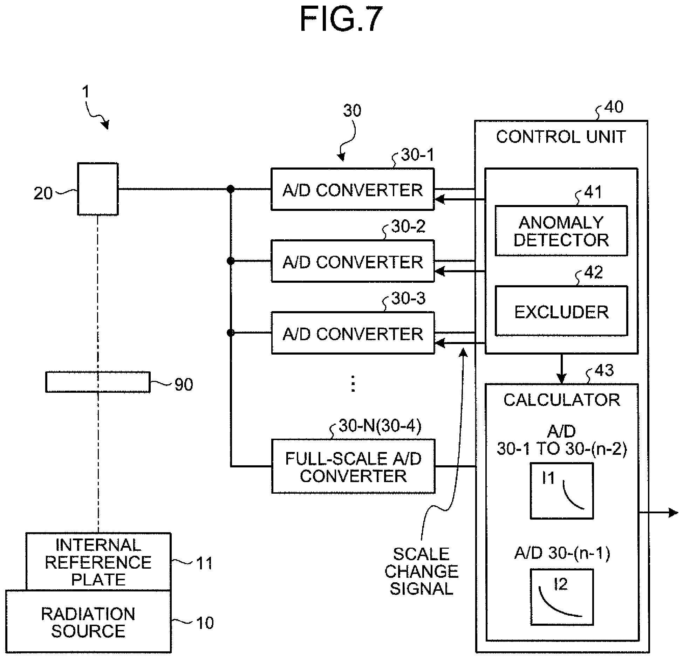

FIG. 7 is a block diagram illustrating a configuration of the thickness measuring device 1 according to a fourth embodiment. The thickness measuring device 1 of the present embodiment differs from the third embodiment in that when the anomaly detector (anomaly detector 41) detects an anomaly of the A/D converter 30-4 for presence or absence determination of the measurement object 90, the control unit 40 transmits, to the A/D converters for thickness measurement, a scale change signal for changing the thickness measurement range of the other A/D converters to a wider range, and determines presence or absence of the measurement object 90 on the basis of the outputs in the changed range.

In the present embodiment, the number of the A/D converters is set to N, and the N-th A/D converter is set as a full-scale A/D converter.

Even with a failure in the A/D converter 30-N for presence or absence determination of the measurement object 90, it is necessary to determine presence or absence of the measurement object 90 and accurately measure the thickness when the thickness T falls within the non-linear region.

According to the thickness measuring device 1 of the present embodiment, when the anomaly detector (anomaly detector 41) determines an anomaly of the A/D converter 30-N for presence or absence determination of the measurement object 90, the control unit 40 excludes the A/D converter 30-N, changes the thickness measurement range of the other A/D converters to a wider range, and determines presence or absence of the measurement object 90 on the basis of the outputs in the changed range.

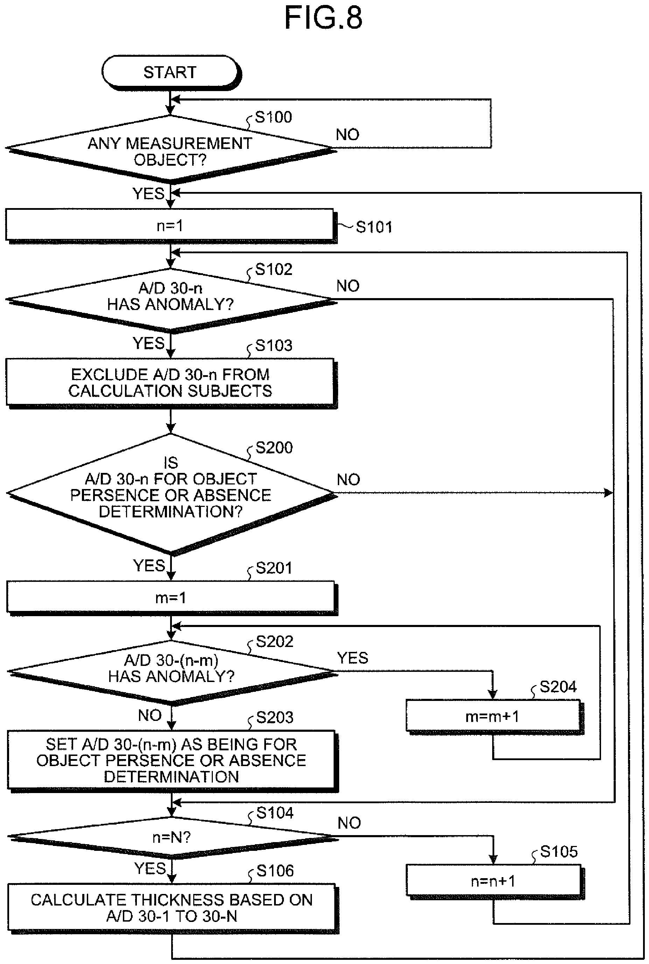

FIG. 8 is a flowchart illustrating the operation of the control unit 40 of the fourth embodiment. The operation of the control unit 40 will now be described with reference to the flowchart in FIG. 8.

The control unit 40 determines whether the measurement object 90 is present between the radiation source 10 and the radiation detector 20 (step S100). With no measurement object 90 found (No at step S100), the control unit 40 continues to determine presence or absence of the measurement object 90. With the measurement object 90 found (Yes at step S100), the control unit 40 receives N digital values from the A/D converters 30, defines the variable n to be 1 (step S101), and detects anomaly or normalcy of the A/D converter 30-n (A/D converter 30-1) (anomaly detector, step S102).

Upon detection of an anomaly of the A/D converter 30-n (Yes at step S102), the control unit 40 excludes the A/D converter 30-n from the subjects of the thickness calculation of the measurement object 90 (excluder, step S103) .

After excluding the A/D converter 30-n having the detected anomaly from the subjects of the calculation, the control unit 40 determines whether the A/D converter 30-n is for presence or absence determination of the measurement object 90 (step S200).

When the A/D converter 30-n is for presence or absence determination of the measurement object 90 (Yes at step S200), the control unit 40 defines a second variable m to be 1 (step S201), and detects anomaly or normalcy of an A/D converter 30-(n-m) (anomaly detector, step S202).

Upon detection of no anomaly of the A/D converter 30-(n-m) (No at step S202), the control unit 40 sets the A/D converter 30-(n-m) as being for presence or absence determination of the measurement object 90 (step S203). The control unit 40 transmits a scale change signal to the A/D converter 30-(n-m).

Upon detection of an anomaly of the A/D converter 30-(n-m) (Yes at step S202), the control unit 40 adds 1 to the second variable m (step S204), and detects anomaly or normalcy of a next A/D converter 30-(n-m) (anomaly detector, step S202).

Upon detection of no anomaly of the A/D converter 30-n (No at step S102), or when the A/D converter 30-n is not for presence or absence determination of the measurement object 90 (No at step S200), or when the A/D converter 30-(n-m) is set as being for presence or absence determination of the measurement object 90 (step S203), the control unit 40 determines whether the first variable n is equal to the total number N of the A/D converters (step S104). If they differ (No at step S104), the control unit 40 adds 1 to the first variable n (step S105), and detects anomaly or normalcy of a next A/D converter 30-n (A/D converter 30-2) (anomaly detector, step S102).

Upon completion of the anomaly detection for all the A/D converters, when the the first variable n becomes equal to the total number N of the A/D converters (Yes at step S104), the calculator 43 of the control unit 40 calculates the thickness of the measurement object 90 on the basis of the non-excluded ones of the A/D converters 30-1 to 30-N (thickness calculator, step S106).

In the example of FIG. 7, when N = 4, the full-scale A/D converter 30-4 determines presence or absence of the measurement object 90, and the A/D converters 30-1 to 30-3 for thickness measurement measure the thickness of the measurement object 90. The anomaly detector (anomaly detector 41) detects normalcy or anomaly of the A/D converters 30-1 to 30-3 for thickness measurement and the A/D converter 30-4 for presence or absence determination of the measurement object 90.

When the anomaly detector (anomaly detector 41) has found an anomaly of the A/D converter 30-4 for presence or absence determination of the measurement object 90, the control unit 40 changes the function of the A/D converter 30-3 from the thickness measurement to the presence or absence determination of the measurement object 90, and continues measuring the thickness of the measurement object 90.

As described above, the thickness measuring device 1 of the present embodiment can determine presence or absence of the measurement object 90, and continuously, accurately measure the thickness irrespective of non-normal values output from the A/D converter for presence or absence determination of the measurement object 90 due to a malfunction.

While some embodiments of the present invention have been described, these embodiments are merely examples, and are not intended to limit the scope of the invention. These novel embodiments may be implemented in various other forms, and various omissions, replacements, and modifications may be made without departing from the scope of the invention, as defined in the appended claims.

## Claims

1. A thickness measuring device (1), comprising:
a radiation source (10) adapted to irradiate a measurement object (90) with radiation;
a radiation detector (20) that is disposed facing the radiation source (10) across the measurement object (90), and that is adapted to detect the radiation transmitted through the measurement object (90);
multiple A/D converters (30) that are individually connected to the radiation detector (20), and that are adapted to convert output signals from the radiation detector (20) to digital values;
a thickness calculator that is adapted to calculate a thickness of the measurement object (90) based on the digital values from the A/D converters (30);
an anomaly detector (41) that is individually adapted to detect an anomaly of the A/D converters (30); and
an excluder (42) that is adapted to exclude an A/D converter (30) having an anomaly detected by the anomaly detector (41), from subjects of calculation by the thickness calculator.

2. The thickness measuring device (1) according to claim 1, wherein the anomaly detector (41) is adapted to detect the anomaly of the A/D converter (30) when a width of an output value of the A/D converter (30) at the time of detection of the radiation transmitted through the measurement object (90) is equal to or more than a certain width relative to a target value.

3. The thickness measuring device (1) according to claim 1, wherein the anomaly detector (41) is adapted to detect the anomaly of the A/D converter (30) based on a central value of output values of the A/D converter (30) at the time of detection of the radiation transmitted through the measurement object (90).

4. The thickness measuring device (1) according to claim 3, wherein the anomaly detector (41) is adapted to detect the anomaly of the A/D converter (30) when the central value of the output values of the A/D converter (30) at the time of detection of the radiation having transmitted through the measurement object (90) is outside a certain width relative to a target value.

5. The thickness measuring device (1) according to claim 3, wherein the anomaly detector (41) is adapted to detect the anomaly of the A/D converter (30) when the central value of the output values of the A/D converter (30) at the time of detection of the radiation having transmitted through the measurement object (90) is outside a range of standard deviation from central values of output values of the A/D converters (30).

6. The thickness measuring device (1) according to any one of claims 1 to 5, wherein the thickness calculator is adapted to calculate an average value of the digital values from the A/D converters (30) as a thickness of the measurement object (90).

7. The thickness measuring device (1) according to any one of claims 1 to 5, wherein
the A/D converters (30) include the A/D converter (30) for presence or absence determination of the measurement object (90) which has a wider thickness measurement range,
the thickness measuring device (1) further comprising
a control unit (40) that is adapted to determine the presence or absence of the measurement object (90) based on an output of the A/D converter (30) for presence or absence determination of the measurement object (90).

8. The thickness measuring device (1) according to claim 7, wherein when the anomaly detector (41) detects an anomaly of the A/D converter (30) for presence or absence determination of the measurement object (90), the control unit (40) is adapted to change a thickness measurement range of the other A/D converter (30) to a wider thickness measurement range and to determine presence or absence of the measurement object (90) based on outputs in the changed thickness measurement range.

## Patentansprüche

1. Dickenmessungsvorrichtung (1), umfassend:
eine Strahlungsquelle (10), die angepasst ist, ein Messungsobjekt (90) mit Strahlung zu bestrahlen;
einen Strahlungsdetektor (20), der zu der Strahlungsquelle (10) zeigend über das Messungsobjekt (90) angeordnet ist, und der angepasst ist, die Strahlung zu erfassen, die durch das Messungsobjekt (90) durchgeht;
mehrere A/D-Wandler (30), die individuell mit dem Strahlungsdetektor (20) verbunden sind und die angepasst sind, Ausgangssignale von dem Strahlungsdetektor (20) zu digitalen Werten umzuwandeln;
einen Dickenrechner, der angepasst ist, eine Dicke des Messungsobjekts (90) basierend auf den digitalen Werten von den A/D-Wandlern (30) zu berechnen;
einen Anomaliedetektor (41), der individuell angepasst ist, eine Anomalie der A/D-Wandler (30) zu erfassen; und
ein Ausschlusselement (42), das angepasst ist, einen A/D-Wandler (30), der eine Anomalie aufweist, die durch den Anomaliedetektor (41) erfasst ist, aus Berechnungssubjekten durch den Dickenrechner auszuschließen.

2. Dickenmessungsvorrichtung (1) nach Anspruch 1, wobei der Anomaliedetektor (41) angepasst ist, die Anomalie des A/D-Wandlers (30) zu erfassen, wenn eine Breite eines Ausgangswerts des A/D-Wandlers (30) zu dem Erfassungszeitpunkt der Strahlung, die durch das Messungsobjekt (90) durchgeht, gleich oder größer als eine gewisse Breite relativ zu einem Zielwert ist.

3. Dickenmessungsvorrichtung (1) nach Anspruch 1, wobei der Anomaliedetektor (41) angepasst ist, die Anomalie des A/D-Wandlers (30) basierend auf einem zentralen Wert von Ausgangswerten des A/D-Wandlers (30) zu dem Erfassungszeitpunkt der Strahlung, die durch das Messungsobjekt (90) geht, zu erfassen.

4. Dickenmessungsvorrichtung (1) nach Anspruch 3, wobei der Anomaliedetektor (41) angepasst ist, die Anomalie des A/D-Wandlers (30) zu erfassen, wenn der zentrale Wert der Ausgangswerte des A/D-Wandlers (30) zu dem Erfassungszeitpunkt der Strahlung, die durch das Messungsobjekt (90) durchgegangen ist, außerhalb einer gewissen Breite relativ zu einem Zielwert ist.

5. Dickenmessungsvorrichtung (1) nach Anspruch 3, wobei der Anomaliedetektor (41) angepasst ist, die Anomalie des A/D-Wandlers (30) zu erfassen, wenn der zentrale Wert der Ausgangswerte des A/D-Wandlers (30) zu dem Erfassungszeitpunkt der Strahlung, die durch das Messungsobjekt (90) durchgegangen ist, außerhalb einer Spanne von Standardabweichung von zentralen Werten von Ausgangswerten der A/D-Wandler (30) ist.

6. Dickenmessungsvorrichtung (1) nach einem der Ansprüche 1 bis 5, wobei der Dickenrechner angepasst ist, einen Durchschnittswert der digitalen Werte von den A/D-Wandlern (30) als eine Dicke des Messungsobjekts (90) zu berechnen.

7. Dickenmessungsvorrichtung (1) nach einem der Ansprüche 1 bis 5, wobei
die A/D-Wandler (30) den A/D-Wandler (30) zur Ermittlung von Gegenwart oder Abwesenheit des Messungsobjekts (90) beinhalten, das eine breite Dickenmessungsspanne aufweist,
die Dickenmessungsvorrichtung (1) weiter umfasst
eine Steuerungseinheit (40), die angepasst ist, die Gegenwart oder Abwesenheit des Messungsobjekts (90) basierend auf einem Ausgang des A/D-Wandlers (30) zur Ermittlung von Gegenwart oder Abwesenheit des Messungsobjekts (90) zu ermitteln.

8. Dickenmessungsvorrichtung (1) nach Anspruch 7, wobei, wenn der Anomaliedetektor (41) eine Anomalie des A/D-Wandlers (30) zur Ermittlung von Gegenwart oder Abwesenheit des Messungsobjekts (90) erfasst, die Steuerungseinheit (40) angepasst ist, eine Dickenmessungsspanne des anderen A/D-Wandlers (30) zu einer breiteren Dickenmessungsspanne zu ändern und Gegenwart oder Abwesenheit des Messungsobjekts (90) basierend auf Ausgängen in der geänderten Dickenmessungsspanne zu ermitteln.

## Revendications

1. Dispositif de mesure d'épaisseur (1), comprenant :
une source de rayonnement (10) adaptée pour irradier un objet à mesurer (90) avec un rayonnement ;
un détecteur de rayonnement (20) qui est disposé face à la source de rayonnement (10) de l'autre côté de l'objet à mesurer (90), et qui est adapté pour détecter le rayonnement transmis à travers l'objet à mesurer (90) ;
de multiples convertisseurs A/N (30) qui sont individuellement connectés au détecteur de rayonnement (20), et qui sont adaptés pour convertir des signaux de sortie provenant du détecteur de rayonnement (20) en valeurs numériques ;
un calculateur d'épaisseur qui est adapté pour calculer une épaisseur de l'objet à mesurer (90) sur la base des valeurs numériques provenant des convertisseurs A/N (30) ;
un détecteur d'anomalie (41) qui est individuellement adapté pour détecter une anomalie des convertisseurs A/N (30) ; et
un moyen d'exclusion (42) qui est adapté pour exclure un convertisseur A/N (30) ayant une anomalie détectée par le détecteur d'anomalie (41), de sujets de calcul par le calculateur d'épaisseur.

2. Dispositif de mesure d'épaisseur (1) selon la revendication 1, dans lequel le détecteur d'anomalie (41) est adapté pour détecter l'anomalie du convertisseur A/N (30) lorsqu'une largeur d'une valeur de sortie du convertisseur A/N (30) au moment de la détection du rayonnement transmis à travers l'objet à mesurer (90) est supérieure ou égale à une certaine largeur par rapport à une valeur cible.

3. Dispositif de mesure d'épaisseur (1) selon la revendication 1, dans lequel le détecteur d'anomalie (41) est adapté pour détecter l'anomalie du convertisseur A/N (30) sur la base d'une valeur centrale des valeurs de sortie du convertisseur A/N (30) au moment de la détection du rayonnement transmis à travers l'objet à mesurer (90).

4. Dispositif de mesure d'épaisseur (1) selon la revendication 3, dans lequel le détecteur d'anomalie (41) est adapté pour détecter l'anomalie du convertisseur A/N (30) lorsque la valeur centrale des valeurs de sortie du convertisseur A/N (30) au moment de la détection du rayonnement ayant été transmis à travers l'objet à mesurer (90) est en dehors d'une certaine largeur par rapport à une valeur cible.

5. Dispositif de mesure d'épaisseur (1) selon la revendication 3, dans lequel le détecteur d'anomalie (41) est adapté pour détecter l'anomalie du convertisseur A/N (30) lorsque la valeur centrale des valeurs de sortie du convertisseur A/N (30) au moment de la détection du rayonnement ayant été transmis à travers l'objet à mesurer (90) est en dehors d'une plage d'écart-type par rapport aux valeurs centrales des valeurs de sortie des convertisseurs A/N (30).

6. Dispositif de mesure d'épaisseur (1) selon l'une quelconque des revendications 1 à 5, dans lequel le calculateur d'épaisseur est adapté pour calculer une valeur moyenne des valeurs numériques provenant des convertisseurs A/N (30) en tant qu'épaisseur de l'objet à mesurer (90).

7. Dispositif de mesure d'épaisseur (1) selon l'une quelconque des revendications 1 à 5, dans lequel
les convertisseurs A/N (30) incluent le convertisseur A/N (30) pour la détermination de la présence ou de l'absence de l'objet à mesurer (90) qui a une plage de mesure d'épaisseur plus large,
le dispositif de mesure d'épaisseur (1) comprenant en outre une unité de commande (40) qui est adaptée pour déterminer la présence ou l'absence de l'objet à mesurer (90) sur la base d'une sortie du convertisseur A/N (30) pour la détermination de la présence ou de l'absence de l'objet à mesurer (90).

8. Dispositif de mesure d'épaisseur (1) selon la revendication 7, dans lequel lorsque le détecteur d'anomalie (41) détecte une anomalie du convertisseur A/N (30) pour la détermination de la présence ou de l'absence de l'objet à mesurer (90), l'unité de commande (40) est adaptée pour modifier une plage de mesure d'épaisseur de l'autre convertisseur A/N (30) en une plage de mesure d'épaisseur plus large et pour déterminer la présence ou l'absence de l'objet à mesurer (90) sur la base des sorties dans la plage de mesure d'épaisseur modifiée.
